# EUROPÄISCHE PATENTANMELDUNG

(11) **EP 4 752 567 A1**
(43) Veröffentlichungstag der Anmeldung: **03.06.2026**
(21) Anmeldenummer: 25215755.7
(22) Anmeldetag: 14.11.2025
(51) Int. Cl.: G01R 19/155, H04R 1/00

(54) **VORRICHTUNG UND VERFAHREN ZUM PRÜFEN EINER ELEKTRISCHEN SPANNUNG**

(30) Priorität: 28.11.2024 DE 102024135332
(71) Anmelder: Pfisterer Kontaktsysteme GmbH, 73650 Winterbach (DE)
(72) Erfinder: Jordan, Steffen, 73527 Schwäbisch Gmünd (DE); Pfeiffer, Jörg, 85542 Herbrechtingen (DE); Fragner, Iris, 89547 Gussenstadt (DE); Krieger, Simon, 89558 Böhmenkirch (DE)
(74) Vertreter: Lorenz & Kollegen

(57) **Zusammenfassung**

Vorrichtung (1) zum Prüfen einer elektrischen Spannung an einer elektrischen Anlage (2), wenigstens aufweisend
- eine Sensoreinrichtung (3) zur Erfassung der Spannung,
- eine Messeinrichtung (4) zur Quantifizierung der elektrischen Spannung an der elektrischen Anlage (2),
- eine Signaleinrichtung (5) mit einer Schallgebereinrichtung (6) zur Anzeige eines Prüfergebnisses mittels wenigstens einer Schallwelle (7),
**dadurch gekennzeichnet**, dass die Signaleinrichtung (5) eine Schallabgabeeinrichtung (8) mit einem Schallbecher (9) aufweist, wobei die Schallgebereinrichtung (6) mittels eines Reflektorelements (10) derart abgedeckt ist, dass die wenigstens eine Schallwelle (7) in Richtung wenigstens eines Zielbereichs (11) des Schallbechers (9) reflektiert wird.

## Beschreibung

Die Erfindung betrifft eine Vorrichtung zum Prüfen einer elektrischen Spannung an einer elektrischen Anlage, wenigstens aufweisend eine Sensoreinrichtung zur Erfassung der Spannung, eine Messeinrichtung zur Quantifizierung der elektrischen Spannung an der elektrischen Anlage sowie eine Signaleinrichtung mit einer Schallgebereinrichtung zur Anzeige eines Prüfergebnisses mittels wenigstens einer Schallwelle.

Die Erfindung betrifft ferner ein Verfahren zum Prüfen einer elektrischen Spannung an einer elektrischen Anlage, mit wenigstens folgenden Schritten:
a) Erfassung der Spannung mittels einer Sensoreinrichtung;
b) Quantifizierung der elektrischen Spannung an der elektrischen Anlage mittels einer Messeinrichtung;
c) Anzeige eines Prüfergebnisses mittels wenigstens einer Schallwelle durch eine Signaleinrichtung mit einer Schallgebereinrichtung.

Aus dem Stand der Technik sind Spannungsprüfer bekannt.

Die DE 35 27 021 C1 offenbart, dass bei einem Spannungsprüfer ein an einem elektrisch isolierenden Griffteil angeordneter Halter außer einer Auswerteelektronik und einer Meldeeinrichtung zwei flächenhafte Sensorelektroden trägt.

Aus der EP 2 549 279 B1 geht eine Vorrichtung zum Prüfen des Vorhandenseins einer elektrischen Gleichspannung als auch einer elektrischen Wechselspannung an einem möglicherweise spannungsführenden Teil einer elektrischen Anlage hervor.

Die DE 10 2005 001 179 A1 offenbart einen einpoligen Spannungsdetektor, welcher eine Kontaktelektrode, einen faradayschen Käfig, eine Detektionsschaltung sowie ein Gegengewicht umfasst.

Aus der DE 1 296 225 geht ein Spannungsprüfer für Gleich- oder Wechselspannung mit einem steuerbaren elektronischen Schaltelement hervor.

Die FR 2 881 526 B1 offenbart ein Verfahren und eine Einrichtung zur Bestimmung der Kenngrößen der Spannung einer elektrischen Installation.

Der US 2009/0319210 A1 ist ein Spannungsprüfer zur Detektion einer Wechselspannung in einem Objekt zu entnehmen.

Die DE 29 15 759 offenbart ein elektrisches Prüfgerät, bestehend aus einer elektrischen Spannungsquelle, einem elektronischen Schwingungserzeuger mit den Anschlüssen für einen äußeren Stromkreis und einem elektronischen Wandler.

Nachteilig bei den aus dem Stand der Technik bekannten Geräten und Methoden zur Spannungsprüfung ist, dass eine Signalübermittlung über das Vorliegen der Spannung an einen Bediener des jeweiligen Geräts entweder mit geringer Lautstärke erfolgt oder das jeweilige Gerät anfällig für elektrische Überschläge in eine Schallöffnung, insbesondere bei hohen Gleichspannungen, ist.

Der vorliegenden Erfindung liegt die Aufgabe zugrunde, eine Vorrichtung zu schaffen, welche die Nachteile des Standes der Technik vermeidet, insbesondere eine effiziente Signalgebung mit ausreichender Lautstärke bei gleichzeitiger Witterungs- und Überschlagsbeständigkeit ermöglicht.

Erfindungsgemäß wird diese Aufgabe durch eine Vorrichtung mit den in Anspruch 1 genannten Merkmalen gelöst.

Der vorliegenden Erfindung liegt ferner die Aufgabe zugrunde, ein Verfahren zu schaffen, welches die Nachteile des Standes der Technik vermeidet, insbesondere auf effiziente Weise ein deutlich hörbares Signal bei gleichzeitiger Witterungs- und Überschlagsbeständigkeit erzeugt.

Erfindungsgemäß wird die Aufgabe durch ein Verfahren mit den in Anspruch 13 genannten Merkmalen gelöst.

Die erfindungsgemäße Vorrichtung zum Prüfen einer elektrischen Spannung an einer elektrischen Anlage umfasst wenigstens:
- eine Sensoreinrichtung zur Erfassung der Spannung,
- eine Messeinrichtung zur Quantifizierung der elektrischen Spannung an der elektrischen Anlage, und
- eine Signaleinrichtung mit einer Schallgebereinrichtung zur Anzeige eines Prüfergebnisses mittels wenigstens einer Schallwelle.

Erfindungsgemäß ist vorgesehen, dass die Signaleinrichtung eine Schallabgabeeinrichtung mit einem Schallbecher aufweist, wobei die Schallgebereinrichtung mittels eines Reflektorelements derart abgedeckt ist, dass die wenigstens eine Schallwelle in Richtung wenigstens eines Zielbereichs des Schallbechers reflektiert wird.

Durch die Reflexion der wenigstens einen Schallwelle in Richtung des wenigstens einen Zielbereichs des Schallbechers, kann sich die Schallwelle zunächst innerhalb des Schallbechers ausbreiten, aus diesem austreten und von dort aus in Richtung eines Bedieners der Vorrichtung geworfen werden.

Hierzu ist der Zielbereich vorzugsweise derart angeordnet, dass die gerichtete Ausbreitung der wenigstens einen Schallwelle in dem Schallbecher unterstützt wird.

Durch das Reflektorelement wird die wenigstens eine Schallwelle mit anderen Worten in den Schallbecher, welcher vorzugsweise als Resonanzkörper wirken kann, eingeleitet. Wenn der Schallbecher in Richtung des Bedieners ausgerichtet ist, verlässt die Schallwelle den Schallbecher in gerichteter Weise in Richtung des Bedieners und erzeugt bei dem Bediener eine gut wahrnehmbare Lautstärke.

Ferner ist die Schallgebereinrichtung durch das Reflektorelement abgedeckt, wodurch ein Eintrag von Witterungseinflüssen, insbesondere von Niederschlagswasser, in Richtung der Schallgebereinrichtung verhindert wird.

Darüber hinaus verhindert das die Schallgebereinrichtung abdeckende Reflektorelement auch einen direkten Überschlag der elektrischen Spannung in Richtung der Schallgebereinrichtung und somit gegebenenfalls in ein Inneres der Vorrichtung.

Es kann vorgesehen sein, dass die wenigstens eine Schallwelle eine derartige Schallfrequenz und/oder Wellenlänge aufweist, dass sich die resultierende Tonhöhe in einem hörbaren Spektrum für das menschliche Gehör befindet.

Vorzugsweise weist die wenigstens eine Schallwelle eine oder mehrere Frequenzen von 10 Hz bis 20 kHz, bevorzugt 1 kHz bis 4 kHz, besonders bevorzugt eine Frequenz von 3 kHz auf.

Es kann vorgesehen sein, dass die Vorrichtung dazu eingerichtet ist, an einem Ohr eines Bedieners eine Lautstärke von 60 Dezibel bis 120 Dezibel, vorzugsweise 67 Dezibel bis 110 Dezibel, besonders bevorzugt 80 Dezibel bis 100 Dezibel zu erzielen.

Es kann ferner vorgesehen sein, dass der Schallbecher in seinen Abmessungen auf die Wellenlänge bzw. ein Wellenlängenspektrum der wenigstens einen Schallwelle abgestimmt ist. Hierdurch kann durch ein Resonanzverhalten eine weitere Lautstärkenerhöhung erzielt werden.

Im Rahmen der Erfindung kann der Schallbecher derart verstanden werden, dass es sich um ein vertieftes Gehäuse und/oder einen vertieften Teil eines Gehäuses handelt, welches eine Kavität bzw. einen Hohlraum aufweist, welcher becherartig ausgebildet ist. Hierdurch sind neben gerade verlaufenden Seitenwänden auch konische Ausbildungen des Schallbechers umfasst. Der Schallbecher kann zudem auch als Schalltrichter ausgebildet sein.

Der Begriff der elektrischen Anlage kann im Rahmen der Erfindung so verstanden werden, dass die zu prüfende elektrische Anlage im Allgemeinen als beliebiger Prüfling, bei welchem das Vorliegen einer Spannung zu prüfen ist, ausgebildet sein kann.

Vorzugsweise ist die Vorrichtung jedoch zur Prüfung von Spannungen an elektrischen Anlagen der Energieversorgung, insbesondere Hochspannungsleitungen, Schaltanlagen und Transformatorstationen oder Teilen davon, eingerichtet.

In einer vorteilhaften Weiterbildung der erfindungsgemäßen Vorrichtung kann vorgesehen sein, dass die Sensoreinrichtung und die Messeinrichtung zur Prüfung von Spannungen von mehr als 1 kV, vorzugsweise mehr als 10 kV, eingerichtet sind.

Sind die Sensoreinrichtung und/oder die Messeinrichtung zur Prüfung von Spannungen von mehr als 1 kV, vorzugsweise mehr als 10 kV, eingerichtet, so ergibt sich ein besonderer Vorteil der vorgenannten Merkmale der Vorrichtung.

Derartig hohe Spannungen sind häufig bei Überlandleitungen zu finden, welche Witterungseinflüssen ausgesetzt sind. Mithin kann es vorkommen, dass eine Messung an derartigen elektrischen Anlagen bei Regen vorgenommen werden muss.

Ferner ist bei derart hohen Spannungen ein deutlich hörbarer Signalton aus Sicherheitsgründen von höchster Bedeutung.

Darüber hinaus ist bei den genannten Spannungen die Gefahr eines in ein Inneres der Vorrichtung vordringenden elektrischen Überschlags besonders groß.

In einer vorteilhaften Weiterbildung der erfindungsgemäßen Vorrichtung kann vorgesehen sein, dass die Schallabgabeeinrichtung einen in einen Boden des Schallbechers mündenden Schallkanal aufweist, an dessen dem Boden abgewandten Ende die Schallgebereinrichtung angeordnet ist.

Ist die Schallabgabeeinrichtung gegen den Boden des Schallbechers durch den Schallkanal beabstandet, so ergibt sich ein vorteilhaft verlängerter Weg für einen elektrischen Spannungsüberschlag. Ferner kann mittels des Schallkanals bei geeigneter Ausbildung eine weitere Ausrichtung der Schallwellenabgabe in Richtung des Bedieners erzielt werden.

Es kann vorgesehen sein, dass der Schallkanal sich erweiternd, insbesondere konisch, vorzugsweise in Form eines Horns, ausgebildet ist. Hierdurch kann eine Lautstärke erhöht werden.

Es kann vorgesehen sein, dass der Schallkanal einen Durchmesser aufweist, welcher 5 % bis 50 %, vorzugsweise 10 %, eines Durchmessers des Schallbechers entspricht.

Es kann vorgesehen sein, dass der Schallkanal einen Querschnitt von 3 mm bis 30 mm, vorzugsweise 5 mm bis 10 mm, aufweist.

Es kann vorgesehen sein, dass der Schallkanal eine Länge von 1 cm bis 20 cm, vorzugsweise 3 cm bis 6 cm, aufweist.

Es kann vorgesehen sein, dass der Schallbecher einen Durchmesser von 3 cm bis 30 cm, vorzugsweise 5 cm bis 10 cm, aufweist.

Es kann vorgesehen sein, dass der Schallbecher eine Höhe von 3 cm bis 20 cm, vorzugsweise 5 cm bis 10 cm, aufweist.

Die Erfinder haben erkannt, dass die genannten Werte im Zusammenspiel mit den bevorzugten Parametern der wenigstens einen Schallwelle ein besonders effektives Erreichen der erfindungsgemäßen Aufgaben ermöglichen.

Dadurch, dass der Schallkanal in den Boden des Schallbechers mündet, liegt die Mündung in dem becherförmig vertieften Gehäuse des Schallbechers. Dies erhöht weiter die Durchschlagfestigkeit der Vorrichtung durch längere Kriechwege für die Spannung und sorgt zugleich für eine höhere Lautstärke durch eine gerichtete Schallabgabe, insbesondere in einem Vergleich zu einer alternativen ebenen Gehäuseform.

In einer vorteilhaften Weiterbildung der erfindungsgemäßen Vorrichtung kann vorgesehen sein, dass das Reflektorelement über der Mündung des Schallkanals angeordnet ist.

Dadurch, dass das Reflektorelement über der Mündung des Schallkanals angeordnet ist, wird der Kriechweg für den elektrischen Spannungsüberschlag weiter vergrößert. Ferner wird der Schallkanal durch das Reflektorelement vor einem direkten Eintrag von Niederschlagswasser geschützt.

Auf diese Weise deckt das Reflektorelement den Schallgeber ab.

Darüber hinaus ermöglicht eine derartige Anordnung des Reflektorelements eine Reflexion der wenigstens einen Schallwelle in Richtung des Bodens des Schallbechers. Vom Boden des Schallbechers aus jedoch kann sich die wenigstens eine Schallwelle in vorteilhafter Weise in dem Schallbecher in Richtung eines dem Boden gegenüberliegenden, offenen oberen Endes des Schallbechers ausbreiten, was zu einer weiteren Verstärkung der Lautstärke führt.

Somit ermöglicht die vorbeschriebene Positionierung des Reflektorelements über der Mündung des Schallkanals eine besonders effektive Lösung der gestellten parallelen Aufgaben der Kriechwegverlängerung, des Regenschutzes und der Lautstärkenerhöhung.

In einer vorteilhaften Weiterbildung der erfindungsgemäßen Vorrichtung kann vorgesehen sein, dass das Reflektorelement eine umlaufende, vorzugsweise schräg angestellte und zu dem Boden hin orientierte, Schürze aufweist.

Dadurch, dass das Reflektorelement die Schürze aufweist, wirkt das Reflektorelement selbst wie ein verkleinerter Schallbecher, welcher umgekehrt innerhalb des Schallbechers angeordnet ist. Hierdurch kann die wenigstens eine Schallwelle vorteilhaft gerichtet auf den Boden des Schallbechers reflektiert werden. Hierdurch ergibt sich ausgehend von dem Zielbereich eine vorteilhaft geradlinige Ausbreitung der wenigstens einen Schallwelle in dem Schallbecher in Richtung der dem Boden abgewandten Öffnung.

Ferner ermöglicht die umlaufende Schürze eine weitere Vergrößerung des Kriechwegs für die Spannung sowie einen zusätzlichen Schutz gegen Niederschlagseintrag, welcher beispielsweise seitlich in den Schallkanal eintreten könnte.

Die vorbeschriebene Schürze des Reflektorelements ermöglicht also die parallel gestellten Aufgaben der Kriechwegverlängerung, des Niederschlagsschutzes und der Lautstärkenerhöhung noch effektiver zu erreichen.

In einer vorteilhaften Weiterbildung der erfindungsgemäßen Vorrichtung kann vorgesehen sein, dass der Schallkanal in einem Bereich der Mündung eine, vorzugsweise umlaufende und/oder domförmige, Erhöhung aufweist.

Die vorzugsweise domförmige Erhöhung verhindert, insbesondere das Zusammenwirken mit dem abdeckenden Reflektorelement, einen Wassereintritt bei Niederschlag. Durch die Erhöhung wird ferner ein Kriechweg für die Spannung weiter erhöht.

In einer vorteilhaften Weiterbildung der erfindungsgemäßen Vorrichtung kann vorgesehen sein, dass die umlaufende Schürze die Erhöhung umgreift.

Es kann vorgesehen sein, dass die Erhöhung eine Höhe aufweist, welche 10 % bis 50 %, vorzugsweise 20 %, eines Durchmessers des Schallbechers aufweist. Bei einer derart gewählten Höhe der Erhöhung kann bei einem Niederschlagsereignis, bei welchem 60 bis 120 l/m² innerhalb einer Stunde fallen, auch bei senkrechter Ausrichtung während eines Spannungsprüfungsvorgangs, insbesondere über wenigstens 1 min, vorzugsweise wenigstens 3 min, oder wenigstens 10 min, mit der Öffnung des Schallbechers nach oben ein Wasserpegel am Boden des Schallbechers die Erhöhung nicht übersteigen.

Hierdurch ist die erfindungsgemäße Vorrichtung besonders geeignet zur Anwendung im Freiland unter Witterungseinflüssen.

Mittels der Vorrichtung, insbesondere wenn die vorbeschriebenen Weiterbildungen realisiert werden, kann auf eine Abdichtung der Mündung des Schallkanals mittels einer Membran verzichtet werden. Ferner ist eine wasserdichte und/oder wasserfeste Ausbildung der Schallgebereinrichtung nicht notwendig. Hierdurch können auf effiziente Weise große Lautstärken erzeugt werden.

In einer vorteilhaften Weiterbildung der erfindungsgemäßen Vorrichtung kann vorgesehen sein, dass die umlaufende Schürze die Erhöhung derart umgreift, dass ein Wellenwiderstand entlang eines Ausbreitungspfads der wenigstens einen Schallwelle angeglichen ist, insbesondere eine lokale Änderung von weniger als einen Faktor 15, vorzugsweise weniger als einen Faktor 10, aufweist.

Bei dem Wellenwiderstand kann es sich insbesondere um eine spezifische Schallimpedanz, besonders um den Quotienten aus den komplexen Amplituden der Feldgrößen Schalldruck und Schallschnelle an einem Punkt des Schallfeldes der wenigstens einen Schallwelle handeln.

Durch die Angleichung des Wellenwiderstands können Rückreflexionen der wenigstens einen Schallwelle, insbesondere an den Übergängen zwischen dem Schallkanal, der Erhöhung, dem Reflektorelement, der Schürze und/oder dem Boden, verringert werden. Hierdurch wird eine nutzbare Lautstärke der wenigstens einen Schallwelle erhöht.

Die vorbeschriebene Konfiguration ermöglicht eine weitere Erhöhung der Lautstärke, da der Wellenwiderstand entlang des Ausbreitungspfads derart ausgestaltet ist, dass sich die Welle mit möglichst ohne Reflexionen entlang des ihr vorgegebenen Wegs auszubreiten vermag.

Insbesondere wird eine Angleichung des Wellenwiderstands im Übergang von dem engen Schallkanal zu dem sehr viel größeren Schallbecher bzw. becherförmigen Gehäusequerschnitt vorgenommen.

Dadurch dass die Schürze vorzugsweise schräg angestellt ist, ergibt sich für die wenigstens eine Schallwelle nach einer Reflexion an dem Boden auf einem Weg zwischen einer Wandung des Schallbechers und der Schürze ein breiter werdender Querschnitt.

Das Reflektorelement als schallreflektierende Abdeckung verhindert somit zusammen mit der vorzugsweise domförmig erhöhten Schallöffnung des Schallkanals einen Wassereintritt bei Niederschlag und erhöht gleichzeitig eine elektrische Durchschlagfestigkeit durch eine labyrinthartige Verlängerung des Kriechwegs für die Spannung.

Vorzugsweise ist der Abstand des Reflektorelements von der Erhöhung und/oder der Abstand der Schürze von dem Boden derart gewählt und/oder die Bauteile sind derart dimensioniert, dass eine freie, unbedeckte Durchtrittsfläche bzw. Querschnittsfläche für die wenigstens eine Schallwelle zwischen den Bauteilen eine lokale Zunahme von weniger als einen Faktor 15, vorzugsweise weniger als einen Faktor 10, aufweist, vorzugsweise sukzessive zunimmt.

Alternativ oder zusätzlich kann vorgesehen sein, dass der Abstand des Reflektorelements von der Erhöhung und/oder der Abstand der Schürze von dem Boden derart gewählt ist und/oder die Bauteile derart dimensioniert sind, dass die freie, unbedeckte Durchtrittsfläche bzw. Querschnittsfläche für die wenigstens eine Schallwelle zwischen den Bauteilen eine lokale Abnahme um weniger als einen Faktor 5, vorzugsweise weniger als einen Faktor 3 aufweist.

Insbesondere kenn vorgesehen sein, dass die umlaufende Schürze die Erhöhung derart umgreift, dass durch die Vorrichtung, insbesondere den Schallkanal, die Erhöhung, das Reflektorelement und den Schallbecher wenigstens annähernd ein gefaltetes Horn ausgebildet wird.

Durch die vorzugsweise stetige Zunahme der unbedeckten Durchtrittsfläche entlang des Ausbreitungspfads kann eine Vergrößerung der schallabstrahlenden Fläche von der Schallgebereinrichtung bis zu der Öffnung des Schallbechers erzielt werden. Durch die hierdurch erfolgte Anpassung an die außerhalb der Vorrichtung vorliegende Schallausbreitung im freien Raum kann eine emittierte Schallleistung der Vorrichtung und damit eine Lautstärke weiter erhöht werden.

Eine Änderung kann als lokal angesehen werden, wenn Sie innerhalb von weniger als 5 mm entlang des Ausbreitungspfades auftritt. Der Wert der Änderung kann insbesondere durch den Wert des Realteils, des Imaginärteils und/oder des Betrags des Wellenwiderstands gegeben sein.

In einer vorteilhaften Weiterbildung der erfindungsgemäßen Vorrichtung kann vorgesehen sein, dass das Reflektorelement derart ausgebildet und angeordnet ist, dass ein elektrischer Kriechweg von der elektrischen Anlage zu der Schallgebereinrichtung, vorzugsweise isotrop, verlängert ist.

Durch die Verlängerung des elektrischen Kriechwegs wird ein direkter Überschlag in die Schallgebereinrichtung verhindert.

Insbesondere kann dies dadurch erreicht werden, dass die Schürze die domförmige Erhöhung derart umgreift, dass sich im Querschnitt ein Überlappen in axialer Richtung zwischen der Schürze und der Erhöhung ergibt.

In einer vorteilhaften Weiterbildung der erfindungsgemäßen Vorrichtung kann vorgesehen sein, dass die Sensoreinrichtung ein Kontaktelement zur elektrischen Kontaktierung der elektrischen Anlage in physischem Kontakt, aufweist; und/oder zur berührungslosen Erfassung der Spannung ein Koppelelement aufweist.

Von besonderem Vorteil ist es, wenn das Kontaktelement zur elektrischen Kontaktierung eine Länge von 0 cm bis 100 cm, vorzugsweise 3 cm bis 30 cm, aufweist.

Es kann auch vorgesehen sein, dass das Kontaktelement wenigstens teilweise als flache Kontaktplatte bzw. Kontaktfläche ausgebildet ist.

Es kann vorgesehen sein, dass das Kontaktelement wenigstens teilweise als Gabel und/oder Haken ausgebildet ist.

Ist die Sensoreinrichtung zur berührungslosen Erfassung der Spannung eingerichtet und weist ein Koppelelement auf, so kann mittels der Vorrichtung ein Abstandsspannungsprüfer realisiert werden, der nicht mit Hochspannung in Kontakt gebracht werden muss.

Es kann vorgesehen sein, dass das Kontaktelement entlang seiner Längserstreckung ein isoliertes Rohr und/oder eine Mehrzahl elektrischer Widerstände und/oder an seiner Spitze ein Metallteil aufweist.

Es kann vorgesehen sein, dass die Sensoreinrichtung das Gehäuse wenigstens teilweise umfasst.

Es kann vorgesehen sein, dass die Sensoreinrichtung wenigstens teilweise aus dem Kontaktelement und/oder den Oberflächen aller leitfähigen Teile innerhalb des Gehäuses ausgebildet wird. Hierdurch kann die Sensoreinrichtung als E-Feldsensor ausgebildet werden.

Es kann vorgesehen sein, dass das Gehäuse einen leitfähigen Abschirmabschnitt aufweist, welcher zur Abschirmung der leitfähigen Teile innerhalb des Gehäuses ausgebildet ist.

Es kann vorgesehen sein, dass wenigstens teilweise die Messeinrichtung, die Schallgebereinrichtung, und/oder die Energiespeichereinrichtung als Teil der Sensoreinrichtung ausgebildet sind bzw. in die Sensoreinrichtung mit einbezogen sind.

Alternativ oder zusätzlich kann vorgesehen sein, dass die Messeinrichtung, die Schallgebereinrichtung, und/oder die Energiespeichereinrichtung in einem Inneren der Sensoreinrichtung angeordnet sind.

Insbesondere kann vorgesehen sein, dass die Sensoreinrichtung eine Abschirmeinrichtung zur Abschirmung von Bauteilen, welche mit dem Abschirmabschnitt wenigstens teilweise identisch sein kann, aufweist. Es kann vorgesehen sein, dass die Messeinrichtung, die Schallgebereinrichtung, und/oder die Energiespeichereinrichtung in der Abschirmeinrichtung der Sensoreinrichtung angeordnet sind.

In einer vorteilhaften Weiterbildung der erfindungsgemäßen Vorrichtung kann ein mit Ausnahme des Schallkanals geschlossenes, vorzugsweise einteiliges, Gehäuse vorgesehen sein.

Es kann vorgesehen sein, dass das Gehäuse eine konische Gesamtform aufweist. Hierdurch ist das Gehäuse in besonders einfacher Weise einteilig herstellbar, da das Gehäuse aus einer bei einem Herstellungsprozess verwendeten Form ausziehbar ist.

Insbesondere kann vorgesehen sein, dass das Gehäuse eine hohe elektrische Durchschlagfestigkeit, insbesondere gegenüber Spannungen von 1 kV bis 400 kV, vorzugsweise 20 kV bis 40 kV, besonders bevorzugt 30 kV, aufweist.

Dadurch, dass das Gehäuse geschlossen, vorzugsweise einteilig, ausgebildet ist, wird die Wahrscheinlichkeit eines elektrischen Überschlags in das Gehäuseinnere bzw. das Innere der Vorrichtung verringert.

In einer vorteilhaften Weiterbildung der erfindungsgemäßen Vorrichtung kann vorgesehen sein, dass die Sensoreinrichtung und/oder die Messeinrichtung zur Prüfung einer Gleichspannung und/oder einer Wechselspannung und/oder zu einem Phasenvergleich der Spannung eingerichtet sind.

Von besonderem Vorteil ist es, wenn die Vorrichtung dazu eingerichtet ist, vor der Durchführung von Arbeiten an elektrischen Anlagen der Mittelspannung und/oder der Hochspannung diese auf Spannungsfreiheit zu überprüfen.

Insbesondere kann vorgesehen sein, dass die Vorrichtung derart ausgebildet ist, dass sie einen Spannungsprüfer gemäß der Norm IEC/EN 61243 darstellt.

Insbesondere kann eine derartige als handgeführtes Gerät ausgeführte Vorrichtung von einer Bedienperson direkt an die gegebenenfalls Hochspannung führende elektrische Anlage gehalten werden. Hierzu ist das Kontaktelement vorzugsweise entsprechend der vorstehenden Ausführungen ausgebildet.

Sind die Sensoreinrichtung und/oder die Messeinrichtung zu einem Phasenvergleich der Spannung eingerichtet, so kann mittels der Vorrichtung ein Phasenvergleicher realisiert werden. Die als Phasenvergleicher ausgeführte Vorrichtung kann für Mittelspannungsanlagen und Hochspannungsanlagen zum Vergleich auf eine korrekte Phasenlage zweier unter Spannung stehende Systeme eingesetzt werden.

Die vorstehend und nachfolgend beschriebenen mechanischen Aufbauten können zu einem Phasenvergleich oder zur Prüfung der Gleichspannung oder der Wechselspannung wenigstens annähernd gleichartig ausgebildet sein.

In einer vorteilhaften Weiterbildung der erfindungsgemäßen Vorrichtung kann vorgesehen sein, dass ein Haltelement vorhanden ist, welches 0,3 m bis 20 m, vorzugsweise 0,5 m bis 10 m lang ist, und bei welchem an einem ersten Ende die Sensoreinrichtung, die Messeinrichtung und die Signaleinrichtung angeordnet sind.

Von Vorteil ist es, wenn die Vorrichtung, sofern sie als handgeführtes Gerät ausgebildet ist, als Halteelement eine Isolierstange zum Schutz der bedienenden Person aufweist. Dies ist von besonderem Vorteil, wenn die Vorrichtung ein Kontaktelement zur Messung in direktem physischem Kontakt aufweist.

Es kann vorgesehen sein, dass das Halteelement aus einem elektrisch isolierenden Material, insbesondere aus einem Polymer und/oder einem glasfaserverstärktem Kunststoff, ausgebildet ist.

Dadurch, dass das Halteelement eine im Vergleich zur menschlichen Körpergröße bedeutende Länge aufweisen kann, werden besondere Anforderungen an die Signaleinrichtung gestellt.

Wenn die Sensoreinrichtung, die Messeinrichtung und die Signaleinrichtung gemeinsam an dem ersten Ende des Halteelements angeordnet sind, befinden sich alle elektrisch aktiven und zur Prüfung der Spannung benötigten Teile der Vorrichtung an dem ersten Ende. Hierdurch kann ein Bediener der Vorrichtung geschützt werden.

Es kann vorgesehen sein, dass die Vorrichtung eine optische Anzeige aufweist, welche vorzugsweise verschiedenfarbige LEDs umfasst.

Bei der erfindungsgemäßen Vorrichtung wird der Signalton von der integrierten Schallgebereinrichtung erzeugt, wobei der Schallaustritt über die Mündung des Schallkanals aus dem Gehäuse heraus erfolgt.

Von besonderem Vorteil ist es hierbei, dass die Mündung sowohl vor Niederschlag als auch vor elektrischen Durchschlägen geschützt ist.

Die durch die vorbeschriebenen Maßnahmen erhöhte Lautstärke hat den Vorteil, dass, insbesondere bei der Verwendung mit hohen Spannungen und somit sehr lang ausgebildeten Halteelementen, eine zuverlässige Signalabgabe für eine bedienende Person ermöglicht wird, wobei die bedienende Person in einem derartigen Fall durch eine lange Isolierstange einige Meter von der Schallgebereinrichtung entfernt sein kann. Ferner können Umgebungsgeräusche hinzukommen.

In einer vorteilhaften Weiterbildung der erfindungsgemäßen Vorrichtung kann vorgesehen sein, dass der Schallbecher in Richtung eines zweiten Endes des Halteelements ausgerichtet ist.

Der Schallbecher kann im Rahmen der Erfindung insbesondere in einem Winkel von -20° bis + 20° zu dem zweiten Ende des Haltelements ausgerichtet sein.

Es kann eine Schrägstellung von 5° bis 25°, insbesondere in Abhängigkeit von einer Länge des Halteelements, vorgesehen sein. Hierdurch kann eine, im Vergleich zu einer exakten Ausrichtung auf das zweite Ende, ergonomischere Bauweise erzielt werden. Ferner kann hierdurch mehr Kriechweg an dem vorzugsweise als Isolierstange ausgebildeten Halteelement bereitgestellt werden.

Es kann eine Schrägstellung von 10° bis 12° vorgesehen sein. Die Erfinder haben diese Schrägstellung als besonders vorteilhaft für die Signalwahrnehmung erkannt.

Es kann auch eine Schrägstellung von 0° vorgesehen sein.

Zur Befestigung des Gehäuses an dem Halteelement kann insbesondere eine Universalzahnkupplung und/oder eine Hirth-Verzahnung verwendet werden. Eine derartige Befestigung kann insbesondere für Reinigungswerkzeuge von Vorteil sein. Für lange Haltelemente, insbesondere wenn die Vorrichtung eine Isolierstangen ab ca. 2 m Länge aufweist, sind insbesondere kleine Winkelinkremente von Vorteil. Es können in diesem Fall auch andere Befestigungssysteme verwendet werden, welche eine Schrägstellung in kleinerem Winkel ermöglichen.

Dadurch, dass der Schallbecher zu der bedienenden Person ausgerichtet ist, kann durch die gerichtete Abgabe der wenigstens einen Schallwelle ein besonders gut vernehmbarer Ton in Richtung der bedienenden Person abgegeben werden.

In einer vorteilhaften Weiterbildung der erfindungsgemäßen Vorrichtung kann vorgesehen sein, dass ein mechanisches Schaltelement zum Ein- und Ausschalten und/oder zum Eigentest der Messeinrichtung, der Sensoreinrichtung und/oder der Signaleinrichtung an einem Boden des Schallbechers angeordnet ist.

Dadurch, dass bereits durch die Versenkung innerhalb des Schallbechers ein Kriechweg für eine Überschlagsspannung erhöht ist, ist es von besonderem Vorteil, wenn das mechanische Schaltelement am Boden des Schallbechers angeordnet ist.

Ferner ermöglicht eine Anordnung des mechanischen Schaltelements am Boden des Schallbechers einen Schutz des mechanischen Schaltelements durch den Schallbecher selbst.

Darüber hinaus ermöglicht die besagte Anordnung des mechanischen Schaltelements am Boden des Schallbechers eine Ausrichtung des Schallbechers insbesondere bei der Durchführung des Eigentests hin zu der bedienenden Person, so dass der Signalton deutlich vernommen werden kann.

In einer vorteilhaften Weiterbildung der erfindungsgemäßen Vorrichtung kann vorgesehen sein, dass das mechanische Schaltelement durch eine Aussparung des Reflektorelements hindurch reicht und/oder an dem Reflektorelement fixierend anliegt.

Von besonderem Vorteil ist es, wenn das Reflektorelement zur Halterung des mechanischen Schaltelements eingerichtet ist. Hierdurch kann eine präzise Führung des mechanischen Schaltelements, welches insbesondere als Tastelement bzw. Taster ausgebildet sein kann, ermöglicht werden.

Insbesondere fixiert das Reflektorelement vorzugsweise das mechanische Schaltelement.

Von besonderem Vorteil ist es, wenn bei einem Vorhandensein eines mechanischen Schaltelements das Reflektorelement zusätzlich derart ausgebildet ist, dass es den elektrischen Kriechweg weiterhin isotrop verlängert.

Hierzu kann es vorgesehen sein, dass das Reflektorelement entsprechend asymmetrisch um die Erhöhung und das mechanische Schaltelement ausgebildet ist.

Auf diese Weise kann eine Niederschlagsfestigkeit der Vorrichtung weiter erhöht werden.

Es kann vorgesehen sein, dass das mechanische Schaltelement an dem Reflektorelement, insbesondere gegenüber Niederschlagswasser, abdichtend anliegt.

In einer vorteilhaften Weiterbildung der erfindungsgemäßen Vorrichtung kann vorgesehen sein, dass eine Energiespeichereinrichtung zur Versorgung der Sensoreinrichtung, der Messeinrichtung und/oder der Signaleinrichtung vorhanden ist.

Wenn ein mechanisches Schaltelement vorgesehen ist, kann auf einen Standby-Modus verzichtet werden, wodurch eine Energieeffizienz der Vorrichtung weiter erhöht wird.

Durch die hohe Lautstärke, welche durch die erfindungsgemäße Vorrichtung erzielt werden kann, kann die Schallgebereinrichtung mit geringem Energieverbrauch betrieben werden. Hierdurch erhöht sich, insbesondere bei einteiligem und/oder geschlossenem Gehäuse, ein Wartungsintervall zum Austausch der Energiespeichereinrichtung, insbesondere wenn diese Batterien umfasst.

In einer vorteilhaften Weiterbildung der erfindungsgemäßen Vorrichtung kann vorgesehen sein, dass die Energiespeichereinrichtung induktiv aufladbar ist und/oder eine Betriebsspannung von wenigstens 1,2 V, vorzugsweise 3 V oder 9 V zur Verfügung stellt.

Bei der Energiespeichereinrichtung kann es sich um einen NiMH-Akkumulator handeln.

Durch ein induktives Aufladen der Energiespeichereinrichtung kann auf ein Öffnen des geschlossenen, insbesondere einteiligen Gehäuses verzichtet werden. Hierdurch weist das Gehäuse vorzugsweise keine Schwachstellen auf und eine Wetterfestigkeit sowie eine Durchschlagsfestigkeit können weiter erhöht werden. Ferner können auch bei geringen Aufladeleistungen große Wartungsintervalle erzielt werden, da bei der erfindungsgemäßen Vorrichtung die Schallgebereinrichtung lediglich wenig Energie verbraucht, da die Lautstärke durch die entsprechende Gestaltung der Vorrichtung erzielt wird.

Die Erfindung betrifft ferner ein Verfahren mit den in Anspruch 13 genannten Merkmalen.

Das erfindungsgemäße Verfahren zum Prüfen einer elektrischen Spannung an einer elektrischen Anlage umfasst wenigstens folgende Schritte:
a) Erfassung der Spannung mittels einer Sensoreinrichtung;
b) Quantifizierung der elektrischen Spannung an der elektrischen Anlage mittels einer Messeinrichtung,
c) Anzeige eines Prüfergebnisses mittels wenigstens einer Schallwelle durch eine Signaleinrichtung mit einer Schallgebereinrichtung, und
d) Abdeckung der Schallgebereinrichtung mittels eines Reflektorelements derart, dass die wenigstens eine Schallwelle in Richtung wenigstens eines Zielabschnitts eines Schallbechers der Signaleinrichtung reflektiert wird.

Das erfindungsgemäße Verfahren hat den Vorteil, dass große Lautstärken zur Signalabgabe effizient und ohne hohen technischen Aufwand erzeugt werden können. Insbesondere ermöglicht das erfindungsgemäße Verfahren einen Verzicht auf hohe Versorgungsspannungen, große Schallgeber, wasserdichte Verklebungen und/oder wasserdichte und zugleich schalldurchlässige Membranen.

Insbesondere ermöglicht das erfindungsgemäße Verfahren eine Spannungsprüfung für Spannungen von mehr als 1 kV in Gleichspannung, Wechselspannung oder auch einen Phasenvergleich mithilfe der schallreflektierenden Abdeckung bzw. des Reflektorelements.

In einer vorteilhaften Weiterbildung des erfindungsgemäßen Verfahrens kann vorgesehen sein, dass die zu prüfende elektrische Spannung mehr als 1 kV, vorzugsweise mehr als 10 kV beträgt.

Das erfindungsgemäße Verfahren eignet sich aufgrund der vorgenommenen Kriechwegverlängerungen für elektrische Überschläge besonders für elektrische Spannungen von mehr als 1 kV.

In einer vorteilhaften Weiterbildung des erfindungsgemäßen Verfahrens kann vorgesehen sein, dass ein Wassereintritt in Richtung der Schallgebereinrichtung bei Niederschlag mittels eines Zusammenwirkens einer, vorzugsweise umlaufenden und/oder domförmigen, Erhöhung, welche eine Mündung eines Schallkanals an einem Boden des Schallbechers umrandet, an dessen dem Boden abgewandten Ende die Schallgebereinrichtung angeordnet ist; und einer Anordnung des Reflektorelements über der Mündung des Schallkanals, wobei das Reflektorelement mit einer umlaufenden, vorzugsweise schräg angestellten und zu dem Boden hin orientierten, Schürze die Erhöhung umgreift, verhindert wird.

Mittels des vorgenannten Vorgehens können Regenraten von 1 mm bis 2 mm pro Minute während eines Spannungsprüfvorganges von wenigstens 3 min, oder wenigstens 10 min, toleriert werden.

In einer vorteilhaften Weiterbildung des erfindungsgemäßen Verfahrens kann vorgesehen sein, dass eine Lautstärke der Anzeige des Prüfergebnisses dadurch erhöht wird, dass die Erhöhung durch die umlaufende, vorzugsweise schräg angestellte, Schürze derart umgriffen wird, dass ein Wellenwiderstand entlang eines Ausbreitungspfads der wenigstens einen Schallwelle angeglichen ist, insbesondere eine lokale Änderung von weniger als einen Faktor 15, vorzugsweise weniger als einen Faktor 10, aufweist.

Mittels der vorbeschriebenen Angleichung des Wellenwiderstands in einem Übergang von dem engen Schallkanal zu dem sehr viel größeren becherförmigen Gehäusequerschnitt kann eine insbesondere in den Normen der Tabelle 1 geforderten Mindestlautstärke der akustischen Anzeige der Signaleinrichtung auch mit geringem Energieaufwand erreicht werden. Ferner werden durch die vorbeschriebenen Ausführungsformen eine Regenfestigkeit und eine elektrische Spannungsfestigkeit, welche in den in der Tabelle 1 dargestellten Normen gefordert werden, ebenfalls erreicht.

**Tabelle 1:**

| | |
|---|---|
| einpolige Spannungsprüfer für Wechselspannung >1kV | IEC / EN 61243-1 |
| einpolige Spannungsprüfer für Hochspannungs-Gleichstrom-Anlagen | noch keine Norm vorhanden |
| zweipolige Spannungsprüfer für Wechselspannung >1kV | IEC / EN 61243-2 |
| Abstandsspannungsprüfer | IEC 61243-6 |
| Phasenvergleicher | IEC / EN-61481-1 und -2 |

In einer vorteilhaften Weiterbildung des erfindungsgemäßen Verfahrens kann vorgesehen sein, dass die erfindungsgemäße Vorrichtung verwendet wird.

Die Verwendung der erfindungsgemäßen Vorrichtung ermöglicht eine einfache und zuverlässige Durchführung der erfindungsgemäßen Verfahrensschritte.

Merkmale, die im Zusammenhang mit einem der Gegenstände der Erfindung, namentlich gegeben durch die erfindungsgemäße Vorrichtung und das erfindungsgemäße Verfahren, beschrieben wurden, sind auch für die anderen Gegenstände der Erfindung vorteilhaft umsetzbar. Ebenso können Vorteile, die im Zusammenhang mit einem der Gegenstände der Erfindung genannt wurden, auch auf die anderen Gegenstände der Erfindung bezogen verstanden werden.

Ergänzend sei darauf hingewiesen, dass Begriffe wie "umfassend", "aufweisend" oder "mit" keine anderen Merkmale oder Schritte ausschließen. Ferner schließen Begriffe wie "ein" oder "das", die auf eine Einzahl von Schritten oder Merkmalen hinweisen, keine Mehrzahl von Merkmalen oder Schritten aus - und umgekehrt.

In einer puristischen Ausführungsform der Erfindung kann allerdings auch vorgesehen sein, dass die in der Erfindung mit den Begriffen "umfassend", "aufweisend" oder "mit" eingeführten Merkmale abschließend aufgezählt sind. Dementsprechend kann eine oder können mehrere Aufzählungen von Merkmalen im Rahmen der Erfindung als abgeschlossen betrachtet werden, beispielsweise jeweils für jeden Anspruch betrachtet. Die Erfindung kann beispielsweise ausschließlich aus den in Anspruch 1 genannten Merkmalen bestehen.

Es sei erwähnt, dass Bezeichnungen wie "erstes" oder "zweites" etc. vornehmlich aus Gründen der Unterscheidbarkeit von jeweiligen Vorrichtungs- oder Verfahrensmerkmalen verwendet werden und nicht unbedingt andeuten sollen, dass sich Merkmale gegenseitig bedingen oder miteinander in Beziehung stehen.

Nachfolgend werden Ausführungsbeispiele der Erfindung anhand der Zeichnung näher beschrieben.

Die Figuren zeigen jeweils bevorzugte Ausführungsbeispiele, in denen einzelne Merkmale der vorliegenden Erfindung in Kombination miteinander dargestellt sind. Merkmale eines Ausführungsbeispiels sind auch losgelöst von den anderen Merkmalen des gleichen Ausführungsbeispiels umsetzbar und können dementsprechend von einem Fachmann ohne Weiteres zu weiteren sinnvollen Kombinationen und Unterkombinationen mit Merkmalen anderer Ausführungsbeispiele verbunden werden.

In den Figuren sind funktionsgleiche Elemente mit gleichen Bezugszeichen versehen.

Es zeigen:
- Figur 1: eine schematische Darstellung einer möglichen Ausführungsform einer erfindungsgemäßen Vorrichtung in einer Schnittansicht;
- Figur 2: eine schematische Darstellung einer weiteren möglichen Ausführungsform der erfindungsgemäßen Vorrichtung in einer Schnittansicht;
- Figur 3: eine schematische Darstellung der Ausführungsform der erfindungsgemäßen Vorrichtung nach Figur 2 in einer Draufsicht;
- Figur 4: eine schematische Darstellung einer weiteren möglichen Ausführungsform der erfindungsgemäßen Vorrichtung in einer Seitenansicht;
- Figur 5: eine schematische Darstellung einer weiteren möglichen Ausführungsform der erfindungsgemäßen Vorrichtung in einer Seitenansicht; und
- Figur 6: eine blockdiagrammmäßige Darstellung einer möglichen Ausführungsform eines erfindungsgemäßen Verfahrens.

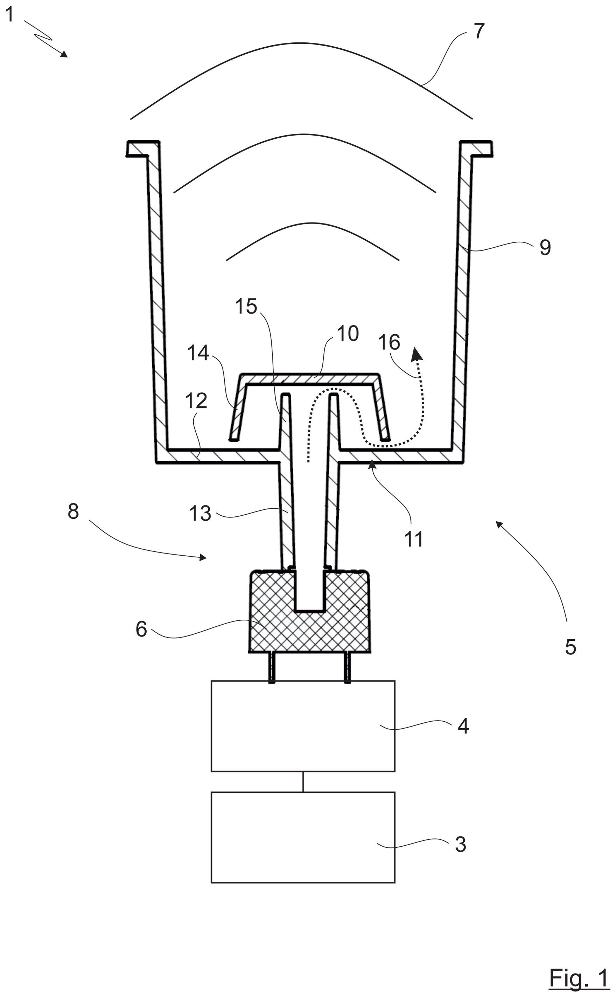

Figur 1 zeigt eine schematische Darstellung einer möglichen Ausführungsform einer Vorrichtung 1 in einer Schnittansicht.

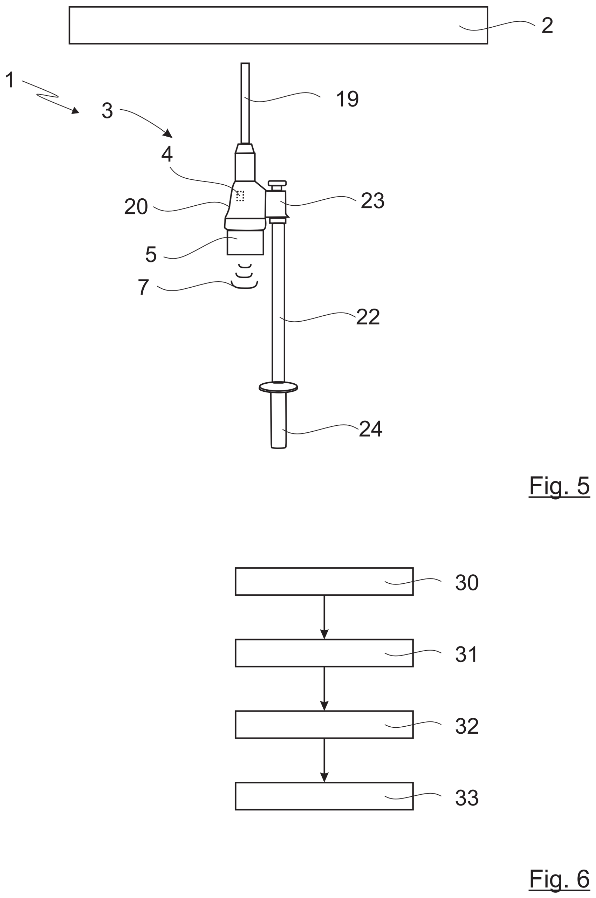

Die Vorrichtung 1 zum Prüfen einer elektrischen Spannung an einer elektrischen Anlage 2 (siehe Figur 5) umfasst wenigstens eine Sensoreinrichtung 3 zur Erfassung der Spannung, eine Messeinrichtung 4 zur Quantifizierung der elektrischen Spannung an der elektrischen Anlage 2 sowie eine Signaleinrichtung 5 mit einer Schallgebereinrichtung 6 zur Anzeige eines Prüfergebnisses mittels wenigstens einer Schallwelle 7.

Bei der Vorrichtung 1 weist die Signaleinrichtung 5 eine Schallabgabeeinrichtung 8 mit einem Schallbecher 9 auf.

Hierbei ist die Schallgebereinrichtung 6 mittels eines Reflektorelements 10 derart abgedeckt, dass die wenigstens eine Schallwelle 7 in Richtung wenigstens eines Zielbereichs 11 des Schallbechers 9 reflektiert wird.

Bei dem in Figur 1 dargestellten Ausführungsbeispiel der Vorrichtung 1 sind die Sensoreinrichtung 3 sowie die Messeinrichtung 4 vorzugsweise zur Prüfung von Spannungen von mehr als 1 kV, besonders bevorzugt mehr als 10 kV, eingerichtet.

Gemäß dem in Figur 1 dargestellten Ausführungsbeispiel weist die Schallabgabeeinrichtung 8 einen in einem Boden 12 des Schallbechers 9 mündenden Schallkanal 13 auf, an dessen dem Boden 12 abgewandten Ende die Schallgebereinrichtung 6 angeordnet ist.

Aus der in Figur 1 dargestellten Ausführungsform der Vorrichtung 1 wird ferner ersichtlich, dass das Reflektorelement 10 über der Mündung des Schallkanals 13 angeordnet ist.

Gemäß der in Figur 1 dargestellten Ausführungsform der Vorrichtung 1 weist das Reflektorelement 10 vorzugsweise eine umlaufende, besonders bevorzugt schräg angestellte und zu dem Boden 12 hin orientierte Schürze 14 auf.

Bei der in Figur 1 dargestellten Ausführungsform der Vorrichtung 1 weist ferner vorzugsweise der Schallkanal 13 in einem Bereich der Mündung eine, vorzugsweise umlaufende und/oder domförmige Erhöhung 15 auf.

Aus der in Figur 1 dargestellten Ausführungsform der Vorrichtung 1 ist ferner ersichtlich, dass die umlaufende Schürze 14 vorzugsweise die Erhöhung 15 umgreift.

Aus der Schnittansicht der Vorrichtung 1 in der Figur 1 geht ferner hervor, dass die umlaufende Schürze 14 die Erhöhung 15 vorzugsweise derart umgreift, dass ein Wellenwiderstand entlang eines Ausbreitungspfads 16 der wenigstens einen Schallwelle 7 angeglichen ist. Insbesondere weist der Wellenwiderstand entlang des Ausbreitungspfads 16 vorzugsweise eine lokale Änderung von weniger als einen Faktor 15, vorzugsweise weniger als einen Faktor 10, auf. Eine lokale Zunahme kann insbesondere bei einem Austritt der wenigstens einen Schallwelle 7 aus dem Inneren des Reflektorelements 10 in den Schallbecher 9 auftreten.

Besonders bevorzugt ist jedoch, dass der von der Schallwelle 7 erfahrene Querschnitt entlang des Ausbreitungspfads 16 der wenigstens einen Schallwelle 7 sukzessive zunimmt.

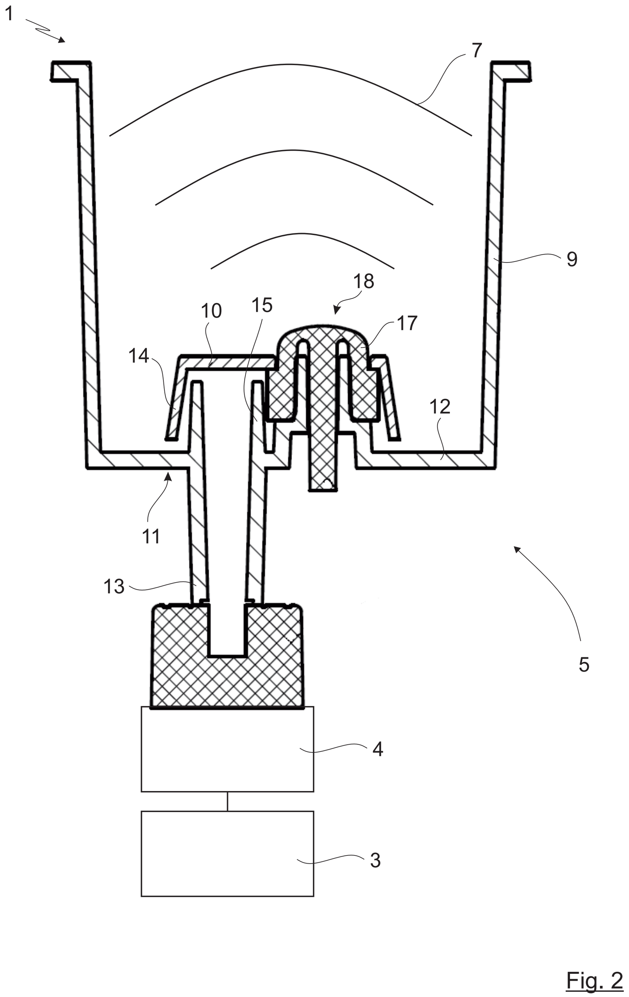

Figur 2 zeigt eine schematische Darstellung einer weiteren möglichen Ausführungsform der Vorrichtung 1 in einer Schnittansicht.

Alternativ oder zusätzlich kann die Darstellung der Figur 2 auch dahingehend verstanden werden, dass sie die Ausführungsform der Figur 1 in einer insbesondere um 90° versetzten Schnittansicht zeigt.

Aus der Darstellung gemäß den Figuren 1 und 2 wird ersichtlich, dass das Reflektorelement 10 vorzugsweise derart ausgebildet und angeordnet ist, dass ein elektrischer Kriechweg von der elektrischen Anlage 2 zu der Schallgebereinrichtung 6 verlängert ist.

Besonders bevorzugt ist das Reflektorelement 10 derart ausgebildet und angeordnet, dass der elektrische Kriechweg isotrop verlängert ist.

Aus der in Figur 2 dargestellten Ansicht wird ersichtlich, dass vorzugsweise ein mechanisches Schaltelement 17 zum Ein- und Ausschalten und/oder zum Eigentest der Messeinrichtung 4, der Sensoreinrichtung 3 und/oder der Signaleinrichtung 5 an dem Boden 12 des Schallbechers 9 angeordnet ist.

Aus der in Figur 2 dargestellten Ausführungsform der Vorrichtung 1 wird ersichtlich, dass das mechanische Schaltelement 17 vorzugsweise durch eine Aussparung 18 des Reflektorelements 10 hindurchreicht und/oder an dem Reflektorelement 10 fixierend anliegt.

Hinsichtlich der weiteren Bezugszeichen sei auf die Figur 1 verwiesen.

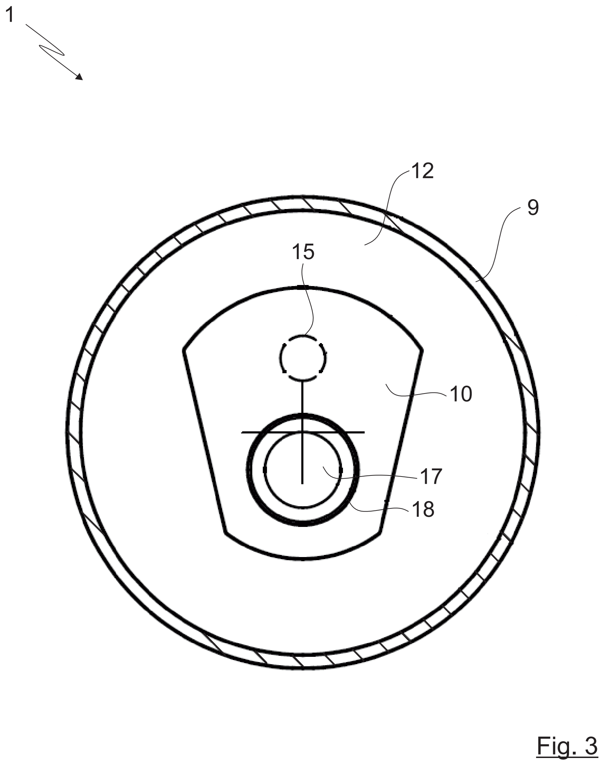

Figur 3 zeigt eine schematische Darstellung der Ausführungsform der Vorrichtung 1 gemäß der Figur 2 in einer Schnittansicht in Draufsicht.

Aus der in Figur 3 dargestellten Ansicht wird ebenfalls ersichtlich, dass vorzugsweise ein mechanisches Schaltelement 17 zum Ein- und Ausschalten und/oder zum Eigentest der Messeinrichtung 4, der Sensoreinrichtung 3 und/oder der Signaleinrichtung 5 an dem Boden 12 des Schallbechers 9 angeordnet ist.

Bei dem in Figur 3 dargestellten Ausführungsbeispiel ist ferner die Mitte des Schallbechers 9 mit einem Fadenkreuz markiert. Hierdurch wird die asymmetrische Anordnung des mechanischen Schaltelements 17 und des Schallkanals 13 ersichtlich.

Ferner wird auch die asymmetrische Ausbildung des Reflektorelements 10 ersichtlich, wodurch der elektrische Kriechweg isotrop verlängert ist.

Hinsichtlich der weiteren Bezugszeichen sei auf die Figuren 1 und 2 verwiesen.

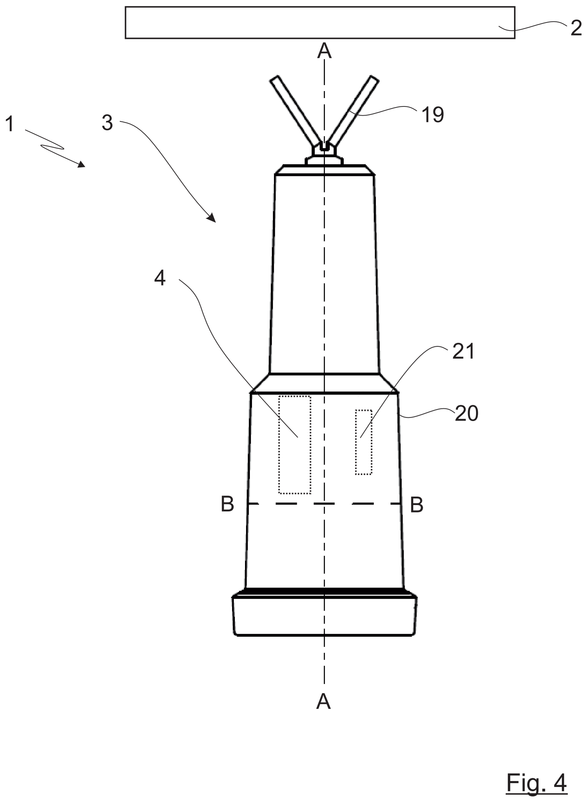

Figur 4 zeigt eine schematische Darstellung einer weiteren möglichen Ausführungsform der Vorrichtung 1 in einer Seitenansicht.

Aus der Seitenansicht gemäß der Figur 4 wird ersichtlich, dass die Sensoreinrichtung 3 vorzugsweise ein Kontaktelement 19 zur elektrischen Kontaktierung der elektrischen Anlage 2 in physischem Kontakt aufweist.

Die Sensoreinrichtung 3 kann hierbei die Messeinrichtung 3, die Schallgebereinrichtung 6, und/oder die Energiespeichereinrichtung 21 umfassen.

In dem in Figur 4 dargestellten Ausführungsbeispiel ist das Kontaktelement 19 als vorzugsweise metallische Gabel mit einer Länge von 2 cm bis 20 cm ausgebildet.

In einem nicht dargestellten Ausführungsbeispiel kann das Kontaktelement 19 wenigstens teilweise als Haken ausgeführt sein.

Hierbei kann es vorgesehen sein, dass der Haken eine Länge von 5 cm bis 50 cm aufweist.

Vorzugsweise weist das Gehäuse 20 einen Abschirmabschnitt auf, welcher zur Abschirmung der leitfähigen Teile innerhalb des Gehäuses 20 ausgebildet ist. Insbesondere kann vorgesehen sein, dass sich der Abschirmabschnitt in Figur 4 oberhalb der Line B-B befindet.

In einer nicht dargestellten Ausführungsform weist die Vorrichtung 1 zur berührungslosen Erfassung der Spannung ein Koppelelement auf.

In Figur 4 sind ferner die Schnittlinien A-A, nach welcher die Schnittdarstellungen der Figuren 1 und 2 dargestellt sind, sowie die Schnittlinie B-B, nach welcher die Figur 3 dargestellt ist, eingezeichnet.

Gemäß dem in Figur 4 dargestellten Ausführungsbeispiel der Vorrichtung 1 ist vorzugsweise ein mit Ausnahme des Schallkanals 13 geschlossenes, vorzugsweise einteiliges Gehäuse 20 vorgesehen.

In dem Gehäuse 20 sind vorzugsweise die Messeinrichtung 4 sowie die Signaleinrichtung 5 angeordnet. Die Sensoreinrichtung 3 steht in Form des Kontaktelements 19 wenigstens teilweise aus dem Gehäuse 20 hervor.

Insbesondere kann der Schallbecher 9 als Vertiefung in dem Gehäuse 20 ausgebildet sein. Hierdurch kann eine einteilige Ausführungsform des Gehäuses 20 zur Erhöhung der Durchschlagfestigkeit erzielt werden.

Aus der Darstellung der Vorrichtung 1 gemäß der Figur 4 wird ersichtlich, dass vorzugsweise eine Energiespeichereinrichtung 21 zur Versorgung der Sensoreinrichtung 3, der Messeinrichtung 4 (gestrichelt dargestellt) und/oder der Signaleinrichtung 5 vorhanden ist.

Die Energiespeichereinrichtung 21 ist vorzugsweise innerhalb des Gehäuses 20 angeordnet und in Figur 4 gestrichelt dargestellt.

Insbesondere kann die Energiespeichereinrichtung 21 induktiv aufladbar sein.

Alternativ oder zusätzlich stellt die Energiespeichereinrichtung 21 vorzugsweise eine Betriebsspannung von wenigstens 1,2 V, vorzugsweise 3 V oder 9 V, zur Verfügung.

Bei dem in Figur 4 dargestellten Ausführungsbeispiel der Vorrichtung 1 sind die Sensoreinrichtung 3 und/oder die Messeinrichtung 4 zur Prüfung einer Gleichspannung und/oder einer Wechselspannung an der elektrischen Anlage 2 und/oder zu einem Phasenvergleich der Spannung an der elektrischen Anlage 2 eingerichtet.

Hinsichtlich der weiteren Bezugszeichen sei auf die Figuren 1 bis 3 verwiesen.

Figur 5 zeigt eine schematische Darstellung einer weiteren möglichen Ausführungsform der Vorrichtung 1 in einer Seitenansicht.

Bei dem in Figur 5 dargestellten Ausführungsbeispiel weist die Vorrichtung 1 vorzugsweise ein Halteelement 22 auf. Das Halteelement 22 ist vorzugsweise 0,3 m bis 20 m, besonders bevorzugt 0,5 m bis 10 m, lang.

In einem nicht dargestellten, aber bevorzugten, Ausführungsbeispiel kann vorgesehen sein, dass der Schallbecher 9 unter einem Winkel gegen das Haltelement 22 schräg gestellt ist.

Bei dem Halteelement 22 sind an einem ersten Ende 23 vorzugsweise die Sensoreinrichtung 3, die Messeinrichtung 4 sowie die Signaleinrichtung 5 angeordnet.

Vorzugsweise sind die Messeinrichtung 4 sowie die Signaleinrichtung 5 wenigstens teilweise in dem Gehäuse 20 angeordnet.

Dadurch, dass die Sensoreinrichtung 3, die Messeinrichtung 4 und die Signaleinrichtung 5 gemeinsam an dem ersten Ende 23 des Halteelements 22 angeordnet sind, befinden sich alle elektrisch aktiven und zur Prüfung der Spannung benötigten Teile der Vorrichtung 1 an dem ersten Ende 23. Hierdurch kann ein Bediener der Vorrichtung 1 geschützt werden.

Bei dem in Figur 5 dargestellten Ausführungsbeispiel der Vorrichtung 1 wird ersichtlich, dass der Schallbecher 9 vorzugsweise in Richtung eines zweiten Endes 24 des Halteelements 22 ausgerichtet ist.

Hierdurch kann die wenigstens eine Schallwelle 7 vorzugsweise direkt auf einen Bediener der Vorrichtung 1 ausgerichtet werden.

In Figur 5 ist das Kontaktelement 19 vorzugsweise als Stab mit einer Länge von 20 cm bis 2 m, besonders bevorzugt 50 cm, ausgebildet. Ferner steht das Kontaktelement 19 aus dem Gehäuse 20 hervor.

Hinsichtlich der weiteren Bezugszeichen sei auf die Figuren 1 bis 4 verwiesen.

Figur 6 zeigt eine blockdiagrammmäßige Darstellung einer möglichen Ausführungsform zum Prüfen der elektrischen Spannung an der elektrischen Anlage 2.

In einem Erfassungsblock 30 erfolgt eine Erfassung der Spannung mittels der Sensoreinrichtung 3.

In einem Prüfblock 31 erfolgt eine Quantifizierung der elektrischen Spannung an der elektrischen Anlage 2 mittels der Messeinrichtung 4.

In einem Anzeigeblock 32 erfolgt eine Anzeige des Prüfergebnisses mittels der wenigstens einen Schallwelle 7 durch die Signaleinrichtung 5 mit der Schallgebereinrichtung 6.

In einem Reflexionsblock 33 erfolgt eine Abdeckung der Schallgebereinrichtung 6 mittels des Reflektorelements 10 derart, dass die wenigstens eine Schallwelle 7 in Richtung des wenigstens einen Zielbereichs 11 des Schallbechers 9 der Signaleinrichtung 5 reflektiert wird.

Im Rahmen der in Figur 6 dargestellten Ausführungsform des Verfahrens beträgt die zu prüfende Spannung vorzugsweise mehr als 1 kV, besonders bevorzugt mehr als 10 kV.

Im Rahmen des Reflexionsblock 33 kann vorzugsweise ein Wassereintritt in Richtung der Schallgebereinrichtung 6 bei Niederschlag mittels eines Zusammenwirkens der vorzugsweise umlaufenden und/oder domförmigen Erhöhung 15, welche die Mündung des Schallkanals 13 an dem Boden 12 des Schallbechers 9 umrandet, an dessen dem Boden 12 abgewandten Ende der Schallgebereinrichtung 6 angeordnet ist und einer Anordnung des Reflektorelements 10 über der Mündung des Schallkanals 13, wobei das Reflektorelement 10 mit der umlaufenden, vorzugsweise schräg angestellten und zu dem Boden 12 hin orientierten Schürze 14 die Erhöhung 15 umgreift, verhindert werden.

Im Rahmen des Anzeigeblocks 32 kann vorzugsweise eine Lautstärkeanzeige des Prüfergebnisses dadurch erhöht werden, dass die Erhöhung 15 durch die umlaufende vorzugsweise schräg angestellte, Schürze 14 derart umgriffen wird, dass der Wellenwiderstand entlang des Ausbreitungspfads 16 der wenigstens einen Schallwelle 7 angeglichen ist, insbesondere eine lokale Änderung von weniger als einen Faktor 15, vorzugsweise weniger als einen Faktor 10, aufweist.

Bei dem in Figur 6 dargestellten Ausführungsbeispiel des Verfahrens wird vorzugsweise die Vorrichtung 1, wie sie im Zusammenhang mit den Figuren 1 bis 5 geschildert wurde, verwendet.

### Bezugszeichenliste

- 1: Vorrichtung
- 2: elektrische Anlage
- 3: Sensoreinrichtung
- 4: Messeinrichtung
- 5: Signaleinrichtung
- 6: Schallgebereinrichtung
- 7: Schallwelle
- 8: Schallabgabeeinrichtung
- 9: Schallbecher
- 10: Reflektorelement
- 11: Zielbereich
- 12: Boden
- 13: Schallkanal
- 14: Schürze
- 15: Erhöhung
- 16: Ausbreitungspfad
- 17: mechanisches Schaltelement
- 18: Aussparung
- 19: Kontaktelement
- 20: Gehäuse
- 21: Energiespeichereinrichtung
- 22: Halteelement
- 23: erstes Ende
- 24: zweites Ende

- 30: Erfassungsblock
- 31: Prüfblock
- 32: Anzeigeblock
- 33: Reflexionsblock

## Patentansprüche

1. Vorrichtung (1) zum Prüfen einer elektrischen Spannung an einer elektrischen Anlage (2), wenigstens aufweisend
- eine Sensoreinrichtung (3) zur Erfassung der Spannung,
- eine Messeinrichtung (4) zur Quantifizierung der elektrischen Spannung an der elektrischen Anlage (2),
- eine Signaleinrichtung (5) mit einer Schallgebereinrichtung (6) zur Anzeige eines Prüfergebnisses mittels wenigstens einer Schallwelle (7),
**dadurch gekennzeichnet, dass**
die Signaleinrichtung (5) eine Schallabgabeeinrichtung (8) mit einem Schallbecher (9) aufweist, wobei die Schallgebereinrichtung (6) mittels eines Reflektorelements (10) derart abgedeckt ist, dass die wenigstens eine Schallwelle (7) in Richtung wenigstens eines Zielbereichs (11) des Schallbechers (9) reflektiert wird.

2. Vorrichtung (1) nach Anspruch 1,
**dadurch gekennzeichnet, dass**
die Sensoreinrichtung (3) und die Messeinrichtung (4) zur Prüfung von Spannungen von mehr als 1 kV, vorzugsweise mehr als 10 kV, eingerichtet sind.

3. Vorrichtung (1) nach Anspruch 1 oder 2,
**dadurch gekennzeichnet, dass**
die Schallabgabeeinrichtung (8) einen in einen Boden (12) des Schallbechers (9) mündenden Schallkanal (13) aufweist, an dessen dem Boden (12) abgewandten Ende die Schallgebereinrichtung (6) angeordnet ist.

4. Vorrichtung (1) nach einem der Ansprüche 1 bis 3,
**dadurch gekennzeichnet, dass**
das Reflektorelement (10) eine umlaufende, vorzugsweise schräg angestellte und zu dem Boden (12) hin orientierte, Schürze (14) aufweist.

5. Vorrichtung (1) nach einem der Ansprüche 3 oder 4,
**dadurch gekennzeichnet, dass**
der Schallkanal (13) in einem Bereich der Mündung eine, vorzugsweise umlaufende und/oder domförmige, Erhöhung (15) aufweist.

6. Vorrichtung (1) nach Anspruch 5 und 6,
**dadurch gekennzeichnet, dass**
die umlaufende Schürze (14) die Erhöhung (15) umgreift,
wobei die umlaufende Schürze (14) die Erhöhung (15) derart umgreift, dass ein Wellenwiderstand entlang eines Ausbreitungspfads (16) der wenigstens einen Schallwelle (7) angeglichen ist, insbesondere eine lokale Änderung von weniger als einen Faktor 15, vorzugsweise weniger als einen Faktor 10, aufweist.

7. Vorrichtung (1) nach einem der Ansprüche 1 bis 6,
**dadurch gekennzeichnet, dass**
das Reflektorelement (10) derart ausgebildet und angeordnet ist, dass ein elektrischer Kriechweg von der elektrischen Anlage (2) zu der Schallgebereinrichtung (6), vorzugsweise isotrop, verlängert ist.

8. Vorrichtung (1) nach einem der Ansprüche 3 bis 7,
**dadurch gekennzeichnet, dass**
ein mit Ausnahme des Schallkanals (13) geschlossenes, vorzugsweise einteiliges, Gehäuse (20) vorgesehen ist.

9. Vorrichtung (1) nach einem der Ansprüche 1 bis 8,
**dadurch gekennzeichnet, dass**
ein Haltelement (22) vorhanden ist, welches 0,3 m bis 20 m, vorzugsweise 0,5 m bis 10 m lang ist, und bei welchem an einem ersten Ende (23) die Sensoreinrichtung (3), die Messeinrichtung (4) und die Signaleinrichtung (5) angeordnet sind.

10. Vorrichtung (1) nach Anspruch 9,
**dadurch gekennzeichnet, dass**
der Schallbecher (9) in Richtung eines zweiten Endes (24) des Halteelements (9) ausgerichtet ist.

11. Vorrichtung (1) nach einem der Ansprüche 1 bis 10,
**dadurch gekennzeichnet, dass**
ein mechanisches Schaltelement (17) zum Ein- und Ausschalten und/oder zum Eigentest der Messeinrichtung (4), der Sensoreinrichtung (3) und/oder der Signaleinrichtung (5) an einem Boden (12) des Schallbechers (9) angeordnet ist.

12. Vorrichtung (1) nach Anspruch 11,
**dadurch gekennzeichnet, dass**
das mechanische Schaltelement (17) durch eine Aussparung (18) des Reflektorelements (10) hindurch reicht und/oder an dem Reflektorelement (10) fixierend anliegt.

13. Verfahren zum Prüfen einer elektrischen Spannung an einer elektrischen Anlage (2), mit wenigstens folgenden Schritten
a) Erfassung der Spannung mittels einer Sensoreinrichtung (3);
b) Quantifizierung der elektrischen Spannung an der elektrischen Anlage (2) mittels einer Messeinrichtung (4),
c) Anzeige eines Prüfergebnisses mittels wenigstens einer Schallwelle (7) durch eine Signaleinrichtung (5) mit einer Schallgebereinrichtung (6),
**gekennzeichnet durch**
d) Abdeckung der Schallgebereinrichtung (6) mittels eines Reflektorelements (10) derart, dass die wenigstens eine Schallwelle (7) in Richtung wenigstens eines Zielbereichs (11) eines Schallbechers (9) der Signaleinrichtung (5) reflektiert wird.

14. Verfahren nach Anspruch 13,
**dadurch gekennzeichnet, dass**
ein Wassereintritt in Richtung der Schallgebereinrichtung (6) bei Niederschlag mittels eines Zusammenwirkens
- einer, vorzugsweise umlaufenden und/oder domförmigen, Erhöhung (15), welche eine Mündung eines Schallkanals (13) an einem Boden (12) des Schallbechers (9) umrandet, an dessen dem Boden (12) abgewandten Ende die Schallgebereinrichtung (6) angeordnet ist; und
- einer Anordnung des Reflektorelements (10) über der Mündung des Schallkanals (13), wobei das Reflektorelement (10) mit einer umlaufenden, vorzugsweise schräg angestellten und zu dem Boden (12) hin orientierte, Schürze (14) die Erhöhung (15) umgreift;
verhindert wird.

15. Verfahren nach Anspruch 14,
**dadurch gekennzeichnet, dass**
eine Lautstärke der Anzeige des Prüfergebnisses dadurch erhöht wird, dass die Erhöhung (14) durch die, vorzugsweise schräg angestellte, umlaufende Schürze (14) derart umgriffen wird, dass ein Wellenwiderstand entlang eines Ausbreitungspfads (16) der wenigstens einen Schallwelle (7) angeglichen ist, insbesondere eine lokale Änderung von weniger als einen Faktor 15, vorzugsweise weniger als einen Faktor 10, aufweist.
